# EUROPÄISCHE PATENTANMELDUNG

(11) **EP 3 640 971 A1**
(43) Veröffentlichungstag der Anmeldung: **22.04.2020**
(21) Anmeldenummer: 19214918.5
(22) Anmeldetag: 16.02.2016
(51) Int. Cl.: H01L 21/20, B23P 19/00, H01L 21/67

(54) **VERFAHREN UND VORRICHTUNG ZUM BONDEN VON SUBSTRATEN**

(62) Teilanmeldung aus: 16706560.6
(71) Anmelder: EV Group E. Thallner GmbH, 4782 St. Florian am Inn (AT)
(72) Erfinder: WAGENLEITNER, Thomas, 4971 Aurolzmünster (AT); FEHKÜHRER, Andreas, 4973 Senftenbach (AT)
(74) Vertreter: Schneider, Sascha

(57) **Zusammenfassung**

Es wird ein Verfahren und eine Vorrichtung zum Bonden zweier Substrate vorgeschlagen.

## Beschreibung

Die vorliegende Erfindung betrifft ein Verfahren und eine Vorrichtung zum Bonden eines ersten Substrats mit einem zweiten Substrat.

Die voranschreitende Miniaturisierung in beinahe allen Teilen der Mikroelektronik und Mikrosystemtechnik sorgt für eine ständige Weiterentwicklung aller Technologien, mit deren Hilfe man die Dichte aller Arten von funktionalen Einheiten auf Substraten steigern kann. Zu diesen funktionalen Einheiten gehören beispielsweise Mikrocontroller, Speicherbausteine, MEMS, alle Arten von Sensoren oder Mikrofluidbauteile.

In den letzten Jahren wurden die Techniken zur Erhöhung der lateralen Dichte dieser funktionalen Einheiten stark verbessert. In einigen Teilbereichen der Mikroelektronik oder Mikrosystemtechnik sogar so weit, dass eine weitere Steigerung der lateralen Dichte der funktionalen Einheiten nicht mehr möglich ist. In der Mikrochipherstellung wurde die maximal erreichbare Auflösungsgrenze für die lithographisch herzustellenden Strukturen bereits so gut wie erreicht. Physikalische oder technologische Beschränkungen erlauben also in wenigen Jahren gar keine Steigerung der lateralen Dichte funktionaler Einheiten mehr. Die Industrie begegnet diesem Problem bereits seit einigen Jahren durch die Entwicklung von 2.5D und 3D Technologien. Mit Hilfe dieser Technologien ist es möglich, gleiche, oder sogar unterschiedlich geartete, funktionale Einheiten zueinander auszurichten, übereinander zu stapeln, sie permanent miteinander zu verbinden und durch entsprechende Leiterbahnen miteinander zu vernetzen.

Eine der Schlüsseltechnologien für die Realisierung solcher Strukturen ist das Permanentbonden. Unter dem Permanentbonden versteht man alle Verfahren, mit deren Hilfe Substrate so miteinander verbunden werden können, dass deren Trennung nur durch hohen Energieaufwand und einer damit einhergehenden Zerstörung der Substrate möglich ist. Es existieren unterschiedliche Arten des Permanentbondens, wie sie dem Fachmann bekannt sind.

Eines der wichtigsten Permanentbondingverfahren ist das Fusionsbonden, auch bezeichnet als Direktbonden oder molekulares Bonden. Unter Fusionsbonden versteht man den zweistufigen Vorgang des permanenten Verbindens zweier Substrate. In der ersten Stufe, auch als Prebond genannt, werden die Substrate über relativ schwache atomare Kräfte wie die van-der-Waalsschen Kräfte zueinander fixiert und in der zweiten Stufe über die Ausbildung kovalenter Verbindungen molekular und/oder atomar miteinander verbunden. Fusionsbonds entstehen vor allem an den Oberflächen von nichtmetallisch-nichtorganischen Materialien.

Die durch den Prebond hervorgerufene Bindungsstärke genügt allerdings, um die beiden Substrate zu transportieren, ohne eine Verschiebung der Substrate zueinander herbeizuführen. Obwohl also die Bindungsstärke zwischen den beiden Substraten sehr wohl ausreicht um den Substratstapel problemlos zu transportieren, ist die Bindungsstärke so gering, dass mit speziellen Vorrichtungen eine erneute, zerstörungsfreie Trennung der beiden Substrate erfolgen kann. Dies hat den entscheidenden Vorteil, dass nach einem Prebond, die Strukturen der beiden Strukturen vermessen und deren relative Positionen, Verzerrungen und Orientierungen bestimmt werden können. Stellt man während des Vermessungsvorgangs fest, dass eine Fehlorientierung und/oder eine lokale und/oder globale Verzerrung der Strukturen vorliegt oder sich Partikel im Interface befinden, kann der Substratstapel wieder entsprechend getrennt und neu prozessiert werden. Nach einem erfolgreichen und vor allem verifizierten Prebond wird durch Wärmebehandlungsprozesse der eigentliche Permanentbond erzeugt. Während des Wärmebehandlungsprozesses kommt es zu einer chemischen und/oder physikalischen Verstärkung der Verbindung der Oberflächen der beiden Substrate durch die Zufuhr der thermischen Energie. Dieser Permanentbond ist irreversibel in dem Sinne, dass eine zerstörungsfreie Trennung der beiden Substrate nicht mehr möglich ist. Im weiteren Verlauf wird nur mehr allgemein von einem Bond gesprochen und nicht mehr explizit zwischen Prebond und Permanentbond unterschieden.

Die gängigsten Fusionsbonds werden an Silizium und Siliziumoxidsubstraten durchgeführt. Silizium dient durch seine Halbleitereigenschaften oft als Basismaterial für die Herstellung von mikroelektronischen Bauteilen wie Mikrochips und Speicher. Ein sogenannter Direktbond kann auch zwischen hochpolierten bzw. geläppten Metalloberflächen oder bei ebenen Glasflächen entstehen. Die zu Grunde liegenden Bindungseigenschaften unterscheiden sich zwar von denen eines Fusionsbonds, der Mechanismus mit dem die beiden Oberflächen durch eine fortschreitende Bondwelle miteinander kontaktiert werden, kann aber durch dieselbe Physik beschrieben werden. Denkbar wäre auch die Verbindung zweier Hybridflächen durch einen sogenannten Hybridbond. Unter einer Hybridfläche versteht man eine aus mindestens zwei unterschiedlichen Materialien bestehende Oberfläche. Eines der beiden Materialien ist dabei meistens auf einen kleinen Raum begrenzt, während das zweite Material das erste Material umgibt. Beispielsweise werden Metallkontakte von Dielektrika umgeben. Bei der Erzeugung eines Hybridbonds durch das Bonden zweier Hybridoberflächen wird die Bondwelle vor allem durch den Fusionsbond zwischen den Dielektrika getrieben, während die Metallkontakte sich durch die Bondwelle automatisch zusammenfinden. Beispiele für Dielektrika und low-k Materialien sind
- Nicht Silizium basierend
   ∘ Polymere
      ▪ Polyimide
      ▪ Aromatische Polymere
      ▪ Parylene
      ▪ PTFE
   ∘ Amorpher Kohlenstoff
- Silizium basierend
   ∘ Silikat basierend
      ▪ TEOS (Tetraethylorthosilikat)
      ▪ SiOF
      ▪ SiOCH
      ▪ Gläser (Borosilikatgläser, Alumosilikatgläser, Bleisilikatgläser, Alkalisilikatgläser, etc.)
   ∘ Allgemein
      ▪ Si₃N₄
      ▪ SiC
      ▪ SiO₂
      ▪ SiCN
   ∘ Silsesquioxane
      ▪ HSSQ
      ▪ MSSQ

Eines der größten technischen Probleme beim permanenten Verbinden zweier Substrate stellt die Ausrichtungsgenauigkeit der funktionalen Einheiten zwischen den einzelnen Substraten dar. Obwohl die Substrate durch Ausrichtungsanlagen genau zueinander ausgerichtet werden können, kann es während des Bondvorgangs selbst zu Verzerrungen der Substrate kommen. Durch die so entstehenden Verzerrungen werden die funktionalen Einheiten nicht notwendigerweise an allen Positionen korrekt zueinander ausgerichtet sein. Die Ausrichtungsungenauigkeit an einem bestimmten Punkt am Substrat kann ein Resultat einer Verzerrung, eines Skalierungsfehlers, eines Linsenfehlers (Vergrößerungs- bzw. Verkleinerungsfehlers) etc. sein. In der Halbleiterindustrie werden alle Themenbereiche, die sich mit derartigen Problemen befassen unter dem Begriff "Overlay" subsumiert. Eine entsprechende Einführung zu diesem Thema findet man beispielsweise in: Mack, Chris. Fundamental Principles of Optical Lithography - The Science of Microfabrication. WILEY, 2007, Reprint 2012*.*

Jede funktionale Einheit wird vor dem eigentlichen Herstellprozess üblicherweise im Computer entworfen. Beispielsweise werden Leiterbahnen, Mikrochips, MEMS, oder jede andere mit Hilfe der Mikrosystemtechnik herstellbare Struktur, in einem CAD (engl.: Computer aided Design) Programm entworfen. Während der Herstellung der funktionalen Einheiten zeigt sich allerdings, dass es immer eine Abweichung zwischen den idealen, am Computer konstruierten, und den realen, im Reinraum produzierten, funktionalen Einheiten gibt. Die Unterschiede sind vorwiegend auf natürliche Schwankungen der verwendeten Materialien, wie bspw. unterschiedliche Anzahl der verschiedenen Isotope im Substratwerkstoff, Limitierungen der Hardware, also ingenieurstechnische Probleme, sehr oft aber auf physikalische Grenzen, zurückzuführen. So ist die Auflösungsgenauigkeit einer Struktur, die durch einen photolithographischen Prozess hergestellt wird, durch die Größe der Aperturen der Photomaske und die Wellenlänge des verwendeten Lichts begrenzt. Maskenverzerrungen werden direkt in den Photoresist übertragen. Antriebe, (Linear-)Motoren sowie mit diesen Komponenten hergestellten Positioniervorrichtungen von Maschinen können nur innerhalb einer vorgegebenen Toleranz reproduzierbare Positionen anfahren, etc. Daher verwundert es nicht, dass die funktionalen Einheiten eines Substrats nicht den am Computer konstruierten Strukturen gleichen können. Alle Substrate besitzen daher bereits vor dem Bondprozess eine nicht vernachlässigbare Abweichung vom Idealzustand.

Vergleicht man nun die Positionen und/oder Formen zweier gegenüberliegender funktionaler Einheiten zweier Substrate unter der Annahme, dass keines der beiden Substrate durch einen Verbindungsvorgang verzerrt wird, so stellt man fest, dass im Allgemeinen bereits eine nicht perfekte Deckung der funktionalen Einheiten vorliegt, da diese durch die oben beschriebenen Fehler vom idealen Computermodell abweichen. Die häufigsten Fehler, werden in Figur XX (*Nachgebildet von: http:*//*commons.wikimedia.org*/*wiki*/*File:Overlay_-_typical_model_terms_DE.svg, 24.05.2013 und* Mack, Chris. Fundamental Principles of Optical Lithography - The Science of Microfabrication. Chichester: WILEY, p. 312, 2007, Reprint 2012) dargestellt. Gemäß den Abbildungen kann man grob zwischen globalen und lokalen bzw. symmetrischen und asymmetrischen Overlayfehlern unterschieden. Ein globaler Overlayfehler ist homogen, daher unabhängig vom Ort. Er erzeugt die gleiche Abweichung zwischen zwei gegenüberliegenden funktionalen Einheiten unabhängig von der Position. Die klassischen globalen Overlayfehler sind die Fehler I. und II., welche durch eine Translation bzw. Rotation der beiden Substrate zueinander entstehen. Die Translation bzw. Rotation der beiden Substrate erzeugt einen dementsprechenden translatorischen bzw. rotatorischen Fehler für alle, jeweils gegenüberliegenden, funktionalen Einheiten auf den Substraten. Ein lokaler Overlayfehler entsteht ortsabhängig, vorwiegend durch Elastizitäts- und/oder Plastizitätsprobleme, im vorliegenden Fall vor allem hervorgerufen durch die sich kontinuierlich ausbreitende Bondwelle. Von den dargestellten Overlay Fehlern werden vor allem die Fehler III. und IV. als "run-out" Fehler bezeichnet. Dieser Fehler entsteht vor allem durch eine Verzerrung mindestens eines Substrats während eines Bondvorgangs. Durch die Verzerrung mindestens eines Substrats werden auch die funktionalen Einheiten des ersten Substrats in Bezug auf die funktionalen Einheiten des zweiten Substrats verzerrt. Die Fehler I. und II. können allerdings ebenfalls durch einen Bondprozess entstehen, werden allerdings von den Fehlern III- und IV. meistens so stark überlagert, dass sie nur schwer erkennbar bzw. messbar sind.

Im Stand der Technik existiert bereits eine Anlage, mit deren Hilfe man lokale Verzerrungen zumindest teilweise reduzieren kann. Es handelt sich dabei um eine lokale Entzerrung durch die Verwendung aktiver Steuerelemente (WO2012/083978A1).

Im Stand der Technik existieren erste Lösungsansätze zur Korrektur von "run-out"-Fehlern. Die US20120077329A1 beschreibt eine Methode, um eine gewünschte Ausrichtungsgenauigkeit zwischen den funktionalen Einheiten zweier Substrate während und nach dem Bonden zu erhalten, indem das untere Substrat nicht fixiert wird. Dadurch ist das untere Substrat keinen Randbedingungen unterworfen und kann während des Bondvorganges frei an das obere Substrat bonden. Ein wichtiges Merkmal im Stand der Technik stellt vor allem die flache Fixierung eines Substrats, meistens mittels einer Vakuumvorrichtung, dar.

Die entstehenden "run-out" Fehler werden in den meisten Fällen radialsymmetrisch um die Kontaktstelle stärker, nehmen daher von der Kontaktstelle zum Umfang zu. In den meisten Fällen handelt es sich um eine linear zunehmende Verstärkung der "run-out" Fehler. Unter speziellen Bedingungen können die "run-out" Fehler auch nichtlinear zunehmen.

Unter besonders optimalen Bedingungen können die "run-out" Fehler nicht nur durch entsprechende Messgeräte (EP2463892) ermittelt, sondern auch durch mathematische Funktionen beschrieben, werden. Da die "run-out" Fehler Translationen und/oder Rotationen und/oder Skalierungen zwischen wohldefinierten Punkten darstellen, werden sie mit Vorzug durch Vektorfunktionen beschrieben. Im Allgemeinen handelt es sich bei dieser Vektorfunktion um eine Funktion f:R²→R², daher um eine Abbildungsvorschrift, die den zweidimensionalen Definitionsbereich der Ortskoordinaten auf den zweidimensionalen Wertebereich von "run-out" Vektoren abbildet. Obwohl noch keine exakte mathematische Analyse der entsprechenden Vektorfelder vorgenommen werden konnte, werden Annahmen bezüglich der Funktionseigenschaften getätigt. Die Vektorfunktionen sind mit großer Wahrscheinlichkeit mindestens Cⁿ n>=1, Funktionen, daher mindestens einmal stetig differenzierbar. Da die "run-out" Fehler vom Kontaktierungspunkt zum Rand hin zunehmen, wird die Divergenz der Vektorfunktion wahrscheinlich von Null verschieden sein. Bei dem Vektorfeld handelt es sich daher mit großer Wahrscheinlichkeit um ein Quellenfeld.

Aufgabe der vorliegenden Erfindung ist es, eine Vorrichtung und ein Verfahren zum Bonden zweier Substrate vorzusehen, mit dem die Bondqualität, insbesondere die Bondgenauigkeit, insbesondere am Rand der Substrate, erhöht wird.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Der Erfindung liegt der Gedanke zugrunde, dass während des Bondens, insbesondere während des Laufs einer Bondwelle, vorzugsweise beim Fusionsbonden, diese Bondwelle beeinflusst wird.

Mit Beeinflussung ist insbesondere eine gezielte, aktive Veränderung und/oder Regelung von einem Anfangszustand mindestens eines Parameters gemeint. Diese Parameter können insbesondere Gaszusammensetzung, Wassergehalt, Druck, Temperatur der Umgebung und/oder des Mediums, in welchem die Bondwelle durchläuft, insbesondere Bondkammervakuum oder - atmosphäre, Einstellung/Veränderung der Form der Substrate und/oder deren Befestigungsverhältnisse, und/oder deren Abstand sein.

Erfindungsgemäß vorgesehen ist ein Verfahren zum Bonden, bevorzugt Permanentbonden, insbesondere Fusionsbonden, eines ersten Substrats mit einem zweiten Substrat innerhalb einer abgeschlossenen Bondkammer, aufweisend die folgenden Schritte:
a) Fixierung der Substrate,
b) Anordnung der Substrate,
c) Annäherung der Substrate,
d) Kontaktierung der Substrate an einer Bondinitiierungsstelle,
e) Erzeugung einer entlang einer von der Bondinitiierungsstelle zu Seitenrändern der Substrate verlaufenden Bondwelle,
f) Beeinflussung der Bondwelle.

In einer bevorzugten Ausführungsform ist vorgesehen, dass im Schritt f) die gezielte Beeinflussung der Bondwelle durch geregelte und/oder gesteuerte Veränderung des Drucks innerhalb der Bondkammer erfolgt. Dadurch ist vorteilhaft eine besonders effiziente Beeinflussung der Bondwelle möglich.

Erfindungsgemäß vorgesehen ist, insbesondere als eigenständiger Gegenstand der Erfindung, insbesondere ein Verfahren zum Bonden, bevorzugt Permanentbonden, insbesondere Fusionsbonden, eines ersten Substrats mit einem zweiten Substrat innerhalb einer abgeschlossenen Bondkammer, aufweisend die folgenden Schritte:
a) Fixierung der Substrate,
b) Anordnung der Substrate,
c) Annäherung der Substrate,
d) Kontaktierung der Substrate an einer Bondinitiierungsstelle,
e) Erzeugung einer entlang einer von der Bondinitiierungsstelle zu Seitenrändern der Substrate verlaufenden Bondwelle, insbesondere durch Lösen der Fixierung mindestens eines der Substrate,
f) Veränderung des Drucks, insbesondere Erhöhung des Drucks, innerhalb der Bondkammer zur Beeinflussung der Bondwelle, insbesondere eine geregelte und/oder gesteuerte Veränderung des Drucks.

Erfindungsgemäß vorgesehen ist insbesondere ein Verfahren zum Bonden, insbesondere als eigenständiger Gegenstand der Erfindung, bevorzugt Permanentbonden, insbesondere Fusionsbonden, eines ersten Substrats mit einem zweiten Substrat innerhalb einer Bondkammer, aufweisend die folgenden Schritte:
a) Fixierung der Substrate,
b) Anordnung der Substrate,
c) Annäherung der Substrate,
d) Kontaktierung der Substrate an einer Bondinitiierungsstelle,
e) Beibehaltung der Fixierung mindestens eines der Substrate und geregeltes Annähern der Substrate zueinander, dadurch Erzeugung einer entlang einer von der Bondinitiierungsstelle zu Seitenrändern der Substrate verlaufenden Bondwelle,
f) Geregelte und/oder gesteuerte Veränderung des Abstandes der Substrate zur Beeinflussung der Bondwelle.

In einer bevorzugten Ausführungsform ist vorgesehen, dass im Schritt e) die Fixierung mindestens eines der Substrate beibehalten wird und die Substrate geregelt einander angenähert werden und dadurch die Bondwelle erzeugt wird, und im Schritt f) die Beeinflussung der Bondwelle durch geregelte und/oder gesteuerte Veränderung des Abstandes der Substrate erfolgt.

Dadurch ist vorteilhaft eine besonders effiziente Beeinflussung der Bondwelle möglich.

Gemäß einer bevorzugten Ausführungsform ist es vorgesehen, dass die Druckveränderung mehr als 1 mbar/s, mit Vorzug mehr als 10 mbar/s, mit größerem Vorzug mehr als 100 mbar/s, mit noch größerem Vorzug mehr als 500 mbar/s, bevorzugter mehr als 1000 mbar/s, am bevorzugtesten mehr als 2000 mbar/s beträgt. Dadurch ist vorteilhaft eine besonders effiziente Beeinflussung der Bondwelle möglich.

Gemäß einer anderen bevorzugten Ausführungsform ist es vorgesehen, dass die Bondwelle derart beeinflusst wird, dass die Geschwindigkeit der Bondwelle um mehr als 0,1 cm/s, mit Vorzug um mehr als 1 cm/s, mit größerem Vorzug um mehr als 10 cm/s, mit besonderem Vorzug um mehr als 100 cm/s, im noch mehr bevorzugten Fall um mehr als 200 cm/s, im bevorzugtesten Fall um mehr als 1000 cm/s verändert wird, insbesondere verlangsamt wird. Dadurch ist vorteilhaft eine besonders effiziente Beeinflussung der Bondwelle möglich.

Gemäß einer anderen bevorzugten Ausführungsform ist es vorgesehen, dass der Druck mit Sensoren innerhalb der Bondkammer gemessen und die Druckveränderung in Abhängigkeit der Messwerte gesteuert wird. Hierdurch ist vorteilhaft eine besonders genaue Steuerung der Druckveränderung möglich.

In deiner bevorzugten Ausführungsform erfolgt die Druckveränderung durch einen beweglichen Kolben, wobei der Kolben das Volumen der Bondkammer verringert. Alternativ und/oder zusätzlich erfolgt die Druckveränderung durch eine Heiz- und/oder Kühleinrichtung, wobei die Heiz- und/oder Kühleinrichtung die Temperatur innerhalb der Bondkammer verändert, insbesondere erhöht. Alternativ oder zusätzlich erfolgt die Druckerveränderung durch eine Pumpe, wobei die Pumpe ein Gas und/oder Gasgemisch in die Bondkammer pumpt und/oder aus der Bondkammer absaugt. Alternativ und/oder zusätzlich wird zur Druckveränderung Gas und/oder ein Gasgemisch aus einem Druckbehälter über ein Ventil in die Bondkammer geleitet und/oder in einem Vakuumbehälter Druck ausgeglichen.

Gemäß einer bevorzugten Ausführungsform ist es vorgesehen, dass zur Druckveränderung ein Gas und/oder Gasgemisch über mindestens eine, bevorzugt mindestens zwei, besonders bevorzugt mindestens drei, ganz besonders bevorzugt mindestens fünf, noch bevorzugter mindestens sieben, am bevorzugtesten mindestens zehn Düsen, insbesondere Spaltdüsen, erfolgt. Dadurch ist vorteilhaft eine besonders effiziente Beeinflussung der Bondwelle möglich.

Ein anderer Gegenstand der vorliegenden Erfindung betrifft einen Artikel, aufweisend zwei Substrate, wobei die Substrate mit einem Verfahren gemäß einer der vorhergehenden Ausführungsformen gebondet wurden.

Ein anderer Gegenstand der vorliegenden Erfindung betrifft eine Anlage zum Bonden, bevorzugt Permanentbonden, insbesondere Fusionsbonden, eines ersten Substrats mit einem zweiten Substrat, insbesondere mit einem Verfahren gemäß einer der vorhergehenden Ausführungsformen, aufweisend:
a) eine Bondkammer,
b) Aufnahmeeinrichtungen zur Aufnahme und Fixierung der Substrate, wobei die Aufnahmeeinrichtungen zur Annäherung der Substrate, zur Kontaktierung der Substrate und zur Erzeugung einer Bondwelle ausgebildet ist,
c) Beeinflussungsmittel zur Beeinflussung der Bondwelle.

In einer bevorzugten Ausführungsform ist es vorgesehen, dass die Beeinflussungsmittel Druckänderungsmittel umfassen zur Veränderung des Drucks innerhalb der Bondkammer zur Beeinflussung der Bondwelle.

Dadurch ist vorteilhaft eine besonders effiziente Beeinflussung der Bondwelle möglich.

In einer bevorzugten Ausführungsform ist es vorgesehen, dass die Beeinflussungsmittel Abstandsveränderungsmittel umfassen zur Veränderung des Abstandes der Substrate zur Beeinflussung der Bondwelle. Dadurch ist vorteilhaft eine besonders effiziente Beeinflussung der Bondwelle möglich.

Ein anderer, insbesondere eigenständiger, Gegenstand der vorliegenden Erfindung betrifft eine Anlage zum Bonden, bevorzugt Permanentbonden, insbesondere Fusionsbonden, eines ersten Substrats mit einem zweiten Substrat, insbesondere mit einem Verfahren gemäß einer der vorhergehenden Ausführungsformen, aufweisend:
a) eine Bondkammer,
b) Aufnahmeeinrichtungen zur Aufnahme und Fixierung der Substrate, wobei die Aufnahmeeinrichtungen zur Annäherung der Substrate, zur Kontaktierung der Substrate und zur Erzeugung einer Bondwelle ausgebildet ist, insbesondere durch Lösen der Fixierung mindestens eines der Substrate,
c) Druckveränderungsmittel zur Veränderung des Drucks innerhalb der Bondkammer, insbesondere Druckerhöhungsmittel, zur Beeinflussung der Bondwelle.

Ein anderer, insbesondere eigenständiger, Gegenstand der vorliegenden Erfindung betrifft eine Anlage zum Bonden, bevorzugt Permanentbonden, insbesondere Fusionsbonden, eines ersten Substrats mit einem zweiten Substrat, insbesondere mit einem Verfahren gemäß einer der vorhergehenden Ausführungsformen, aufweisend:
a) eine Bondkammer,
b) Aufnahmeeinrichtungen zur Aufnahme und Fixierung der Substrate, wobei die Aufnahmeeinrichtungen zur Annäherung der Substrate, zur Kontaktierung der Substrate und zur Erzeugung einer Bondwelle ausgebildet ist,
c) Abstandsveränderungsmittel zur Veränderung des Abstandes der Substrate zur Beeinflussung der Bondwelle.

Das Bonden wird mittels einer Kontaktierung der Kontaktflächen auf dem Fachmann bekannte Weise initiiert. Entsprechende Bondmittel sind vorrichtungsgemäß insbesondere vorgesehen.

Im Ausgangszustand sind die Substrate im Regelfall, insbesondere an einer Kontaktfläche, mehr oder weniger eben, abgesehen von etwaigen die Kontaktfläche überragenden Strukturen (Mikrochips, funktionale Bauteile) und Substrattoleranzen wie Biegung und/oder Dickenschwankungen. Die Substrate besitzen im Ausgangszustand aber in den meisten Fällen eine von Null verschiedene Krümmung. Für einen 300 mm Wafer sind Krümmungen von weniger als 50µm üblich. Mathematisch gesehen kann eine Krümmung als ein Maß für die lokale Abweichung einer Kurve von ihrem ebenen Zustand angesehen werden. Im konkreten Fall werden Substrate betrachtet, deren Dicken gering im Vergleich zum Durchmesser sind. Daher kann man in guter Näherung von der Krümmung einer Ebene sprechen. Im Fall einer Ebene ist der anfangs erwähnte, ebene Zustand die Tangentialebene der Kurve im Punkt, an welchem man die Krümmung betrachtet. Im Allgemeinen besitzt ein Körper, im speziellen Fall das Substrat, keine homogene Krümmung, so dass die Krümmung eine explizite Funktion des Ortes ist. So kann es beispielsweise sein, dass ein nicht ebenes Substrat im Zentrum eine konkave Krümmung, an anderen Stellen allerdings eine konvexe Krümmung aufweist. Im weiteren Verlauf werden Krümmungen im einfachsten Fall immer nur als konkav oder konvex beschrieben, ohne auf nähere mathematische Einzelheiten einzugehen, die Mathematikern, Physikern und Ingenieuren bekannt sind.

Ein, insbesondere eigenständiger, Kerngedanke für die meisten erfindungsgemäßen Ausführungsformen besteht vor allem darin, dass die Krümmungsradien der zwei miteinander zu verbondenden Substrate zumindest im Kontaktierungsbereich der Substrate, also an einer Bondfront der Bondwelle bzw. an der Bondlinie gleich sind, oder zumindest nur marginal voneinander abweichen. Die Differenz der beiden Krümmungsradien an der Bondfront/Bondlinie der Substrate ist dabei kleiner als 10m, mit Vorzug kleiner als Im, mit größerem Vorzug kleiner als 1cm, mit größtem Vorzug kleiner als 1mm, mit allergrößtem Vorzug kleiner als 0.01mm, am bevorzugtesten kleiner als 1µm. Im Allgemeinen sind alle erfindungsgemäßen Ausführungsformen von Vorteil, welche den Krümmungsradius minimieren. Mit anderen Worten: Die Erfindung betrifft eine Methode und eine Anlage, mit deren Hilfe man in der Lage ist, zwei Substrate so miteinander zu verbonden, dass deren lokale Ausrichtungsfehler, die man als "run-out" Fehler bezeichnet, minimal werden.

Der Erfindung liegt dabei weiterhin der Gedanke zu Grunde, die beiden miteinander zu verbondenden Substrate, insbesondere durch geometrische, thermodynamische, fluiddynamische und/oder mechanische Kompensationsmechanismen, so zu steuern, dass die Einflussfaktoren auf die sich ausbildende Bondwelle so gewählt werden, dass die beiden Substrate sich während des Bondens lokal nicht zueinander verschieben, also richtig ausgerichtet sind. Des Weiteren beschreibt die Erfindung einen Artikel, bestehend aus zwei miteinander verbondeten Substraten mit erfindungsgemäß reduziertem "run-out" Fehler.

Ein erfindungsgemäß charakteristischer Vorgang beim Bonden, insbesondere Permanentbonden, vorzugsweise Fusionsbonden, ist die möglichst zentrische, punktförmige Kontaktierung der beiden Substrate. Im Allgemeinen kann die Kontaktierung der beiden Substrate auch nicht zentrisch erfolgen. Die sich von einem nicht-zentrischen Kontaktpunkt ausbreitende Bondwelle würde unterschiedliche Stellen des Substratrandes zu unterschiedlichen Zeiten erreichen. Entsprechend kompliziert wäre die vollständige mathematischphysikalische Beschreibung des Bondwellenverhaltens und der daraus resultierenden "run-out" Fehler Kompensation. Im Allgemeinen wird allerdings der Kontaktierungspunkt nicht weit vom Zentrum des Substrats entfernt liegen, sodass die sich daraus möglicherweise ergebenden Effekte, zumindest am Rand vernachlässigbar sind. Die Distanz zwischen einem möglichen nicht-zentrischen Kontaktierungspunkt und dem Zentrum des Substrats ist dabei kleiner als 150mm, mit Vorzug kleiner als 10mm, mit größerem Vorzug kleiner als 1mm, mit größtem Vorzug kleiner als 0.1mm, mit allergrößtem Vorzug kleiner als 0.01mm. Im weiteren Verlauf der Beschreibung soll unter Kontaktierung im Regelfall eine zentrische Kontaktierung gemeint sein. Unter Zentrum versteht man im weiteren Sinne mit Vorzug den geometrischen Mittelpunkt eines zugrundeliegenden, wenn nötig um Asymmetrien kompensierten, idealen Körpers. Bei industrieüblichen Wafern mit einem Notch (Einkerbung zur Signalisierung der Kristallebene) ist das Zentrum also der Kreismittelpunkt des Kreises, der den idealen Wafer ohne notch, umgibt. Bei industrieüblichen Wafern mit einem Flat (abgeflachte Seite) ist das Zentrum der Kreismittelpunkt des Kreises, der den idealen Wafer ohne flat, umgibt. Analoge Überlegungen gelten für beliebig geformte Substrate.

Für das Starten einer Bondwelle sind die Substrate mittels translatorischer Annäherung insbesondere zentrisch, punktförmig in Kontakt zu bringen. Es ist jedoch jeder beliebige Kontaktpunkt theoretisch möglich.

In speziellen Ausführungsformen kann es allerdings von Nutzen sein, unter dem Zentrum den Schwerpunkt des Substrats zu verstehen.

Es wird mit Vorzug das obere Substrat von mindestens einem der beiden Substrate, auf Grund der Gravitation eine aufgeprägte Krümmung in Richtung des anderen Substrats besitzen, und daher bei der erwähnten translatorischen Annäherung, bei genügend geringem Abstand zum entsprechenden zweiten Substrat, automatisch kontaktiert.

Nach der erfolgten Kontaktierung der Zentren beider Substrate kann die Fixierung des oberen Substrathalters gelöst werden. Das obere Substrat fällt einerseits durch die Schwerkraft und andererseits bedingt durch eine entlang der Bondwelle und zwischen den Substraten wirkende Bondkraft nach unten. Das obere Substrat wird radial vom Zentrum zum Seitenrand hin mit dem unteren Substrat verbunden. Es kommt so zu einer erfindungsgemäßen Ausbildung einer radialsymmetrischen Bondwelle, die insbesondere vom Zentrum zum Seitenrand verläuft. Während des Bondvorganges drücken die beiden Substrate das zwischen den Substraten vorliegende Gas, insbesondere Luft, vor der Bondwelle her und sorgen damit für eine Bondgrenzfläche ohne Gaseinschlüsse. Das obere Substrat liegt während des Fallens praktisch auf einer Art Gaspolster.

Der Erfindung liegt der Gedanke zu Grunde, dass die Beeinflussung des Bondes, insbesondere Fusionsbondes mit der Beeinflussung des Gaspolsters insbesondere mittels Gegendruckprinzip realisiert wird. Erfindungsgemäß wird das Kräfteverhältnis zwischen den Prebond verursachenden anziehenden schwachen Kräften und der Gegenkraft, welche mittels Temperatur, Druck, Strömungsverhältnisse oder mechanische Krafteinwirkung erzeugt wird, aktiv und dynamisch beeinflusst.

Das erste/obere Substrat unterliegt nach der Initiierung des Bonds an einer Bondinitiierungsstelle keiner zusätzlichen Fixierung, kann sich also abgesehen von der Fixierung an der Bondinitiierungsstelle frei bewegen und auch verzerren. Durch die voranschreitende Bondwelle, die an der Bondwellenfront auftretenden Spannungszustände und die vorliegenden geometrischen Randbedingungen wird jedes, insbesondere bezüglich seiner radialen Dicke infinitesimal kleine, Kreissegment einer Verzerrung unterliegen. Als infinitesimal kleines Kreissegment wird ein Kreissegment verstanden, welches für mathematische Berechnungen herangezogen werden kann. Die radiale Dicke des Kreissegments kann kleiner sein als 1 mm, vorzugsweise kleiner als 100 µm, noch bevorzugter kleiner als 10 µm, am bevorzugtesten kleiner als 1 µm, am allerbevorzugtesten kleiner als 0.1 µm. Da die Substrate allerdings starre Körper darstellen, summieren sich die Verzerrungen als Funktion des Abstandes vom Zentrum her auf. Dies führt zu "run-out" Fehlern, die durch das erfindungsgemäße Verfahren und die erfindungsgemäße Vorrichtung beseitigt werden sollen.

Die Erfindung betrifft somit auch ein Verfahren und eine Vorrichtung, um den "run-out"-Fehler zwischen zwei gebondeten Substraten, insbesondere durch thermodynamische und/oder mechanische und/oder fluiddynamische Kompensationsmechanismen, beim Bonden zu verringern oder sogar ganz zu vermeiden. Des Weiteren behandelt die Erfindung einen entsprechenden Artikel, der mit der erfindungsgemäßen Vorrichtung und dem erfindungsgemäßen Verfahren hergestellt wird.

Das erste und/oder zweite Substrat ist mit Vorzug radialsymmetrisch. Obwohl das Substrat jeden beliebigen Durchmesser besitzen kann, ist der Waferdurchmesser insbesondere 1 Zoll, 2 Zoll, 3 Zoll, 4 Zoll, 5 Zoll, 6 Zoll, 8 Zoll, 12, Zoll, 18 Zoll oder größer als 18 Zoll. Die Dicke des ersten und/oder zweiten Substrats liegt zwischen 1 µm und 10000µm, mit Vorzug zwischen 10µm und 1500µm, mit größerem Vorzug zwischen 100µm und 1000µm.

Die Dicke des Substratstapels liegt zwischen 1 µm und 10000 µm, mit Vorzug zwischen 10 µm und 20 mm.

In besonderen Ausführungsformen kann ein Substrat auch eine rechteckige, oder zumindest von der kreisförmigen Gestalt abweichende, Form besitzen. Unter einem Substrat wird im weiteren Verlauf insbesondere ein Wafer verstanden.

In einer erfindungsgemäßen Ausführungsform wird die untere/erste Aufnahmeeinrichtung so ausgebildet, dass das untere/erste Substrat durch Heiz- und/oder Kühlmittel noch vor der Kontaktierung gezielt verformt, insbesondere lateral gestaucht oder gedehnt, wird, und zwar um den Betrag, der bei der späteren Kontaktierung notwendig ist, um den entstehenden "run-out" Fehler bestmöglich, im Idealfall vollständig, zu kompensieren.

Da die Fixierung des unteren/ersten Substrats in dieser Ausführungsform erst nach der entsprechenden Verformung erfolgt, muss man keinen besonderen Wert auf die thermischen Ausdehnungskoeffizienten des unteren/ersten Substrats bzw. der unteren/ersten Aufnahmeeinrichtung legen.

In einer weiteren besonderen, erfindungsgemäßen Vorgehensweise erfolgt die Kontaktierung des unteren/ersten Substrats vor einem Heiz- und/oder Kühlvorgang. Durch die Fixierung vor dem Heiz- und/oder Kühlvorgang folgt das untere/erste Substrat der thermischen Dehnung der unteren/ersten Aufnahmeeinrichtung, sodass deren thermischer Ausdehnungskoeffizient genutzt werden kann, um die (thermische) Dehnung des Substrats vorzugeben. Mit Besonderem Vorzug sind die thermischen Ausdehnungskoeffizienten des unteren/ersten Substrats und der unteren/ersten Aufnahmeeinrichtung gleich, sodass beim Heiz- und/oder Kühlvorgang keine oder zumindest geringe thermische Spannungen im unteren/ersten Substrat entstehen. Erfindungsgemäß denkbar wäre es auch, dass die thermischen Ausdehnungskoeffizienten unterschiedlich sind. Im Falle unterschiedlicher thermischer Ausdehnungskoeffizienten wird das untere/erste Substrat im Mittel der thermischen Dehnung der unteren/ersten Aufnahmeeinrichtung folgen.

Die einzustellenden Temperaturdifferenzen zwischen der ersten und zweiten Aufnahmeeinrichtung betragen dabei weniger als 20°C, mit Vorzug wenig als 10°C, mit größerem Vorzug weniger als 5°C, mit größtem Vorzug weniger als 2°C, mit allergrößtem Vorzug weniger als 1°C. Jede Aufnahmeeinrichtung wird erfindungsgemäß möglichst homogen durchwärmt. Insbesondere ist ein Temperaturfeld vorgesehen, dessen Temperaturdifferenz an zwei beliebigen Punkten kleiner als 5°C ist, mit Vorzug kleiner als 3°C, mit größerem Vorzug kleiner als 1°C, mit größtem Vorzug kleiner als 0.1°C, mit allergrößtem Vorzug kleiner als 0.05°C ist.

In einer weiteren Ausführungsform wird die erste Aufnahmeeinrichtung so konstruiert, dass die Aufnahmeeinrichtung an der Aufnahmefläche gezielt durch mechanische Stellmittel verformt, insbesondere gestaucht und/oder gedehnt, werden kann. Das auf der Oberfläche der ersten Aufnahmeeinrichtung fixierte erste Substrat wird auf Grund seiner in Bezug auf die Aufnahmeeinrichtung geringen Dicke durch die Verformung der Aufnahmeeinrichtung mit verformt. Die Verformung der Aufnahmeeinrichtung erfolgt dabei mit pneumatischen und/oder hydraulischen und/oder piezoelektrischen Aktuatoren, die, mit Vorzug radialsymmetrisch, um die Substrataufnahme verteilt angeordnet worden sind. Für eine vollständig symmetrische, rein radiale Verzerrung benötigt man mindestens drei Aktuatoren, die zueinander in einem Winkelabstand von 120° angeordnet sind. Mit Vorzug werden mehr als 5 Aktuatoren, mit größerem Vorzug mehr als 10 Aktuatoren, mit größerem Vorzug mehr als 20 Aktuatoren, mit größtem Vorzug mehr als 30 Aktuatoren, mit allergrößtem Vorzug mehr als 50 Aktuatoren, verwendet.

In einer weiteren erfindungsgemäßen Ausführungsform werden die Kontaktflächen der beiden Substrate in einer vertikalen Lage miteinander gebondet. Die Aufgabe dieser speziellen Ausführungsform besteht vor allem darin, die Verformung der Wafer durch die Gravitation zu reduzieren, mit Vorzug zumindest symmetrisch anzuordnen, mit besonderem Vorzug eine Verformung durch Gravitation ganz zu verhindern und/oder zu kompensieren. Mit Vorzug werden in der vertikalen Position beide Substrate, insbesondere gleichzeitig, symmetrisch zur Bondinitiierungsstelle durch je ein Stellmittel, insbesondere je einen Stift, zur Bondinitiierungsstelle hin gekrümmt, sodass die konvexen Oberflächen in der Bondinitiierungsstelle kontaktiert werden können. Der, insbesondere selbsttätige, Bondvorgang mit Bondwelle wird durch Loslösen und darauffolgender Kontaktierung mindestens eines der Substrate von der Aufnahmefläche gestartet.

In einer weiteren erfindungsgemäßen Ausführungsform wird mindestens ein Einflussfaktor auf die Ausbreitung, insbesondere Ausbreitungsgeschwindigkeit der Bondwelle und/oder mindestens ein Einflussfaktor auf die Ausrichtung der Kontaktflächen, gesteuert. Die Bondwelle wird insbesondere bezüglich Ihrer Geschwindigkeit kontrolliert. Die Steuerung der Geschwindigkeit erfolgt dynamisch insbesondere indirekt über die Zusammensetzung und/oder die Dichte und/oder die Temperatur und/oder Druck eines Gases in der Atmosphäre, in der gebondet wird.

In einer weiteren erfindungsgemäßen Ausführungsform kann nach der Kontaktierung der Zentren beider Substrate die Fixierung des insbesondere oberen Substrathalters aufrechterhalten bleiben. Demnach kann die Bondwelle bzw. deren Ausbreitung mit der Beeinflussung des Abstands der Substrate zueinander verändert und/oder gestoppt werden. Somit ist durch eine Abstandsregelung eine reproduzierbare Beeinflussung der Bondwelle möglich.

Die erfindungsgemäßen Ausführungsformen werden mit Vorzug in einer definierten, insbesondere steuerbaren und/oder regelbaren Atmosphäre betrieben. Diese Atmosphäre wird mit Vorzug in einem definierten, abgeschlossenen Raumabschnitt, in der Bondkammer erzeugt.

Obwohl das erfindungsgemäße Verfahren bevorzugt in einer Niederdruckatmosphäre, mit Vorzug im Vakuum durchgeführt werden soll, kann es vorteilhaft sein, den Bondprozess in einer anderen Atmosphäre, insbesondere im Bereich des Normaldrucks oder Überdrucks durchzuführen.

Durch den punktförmigen Kontakt läuft die Bondwelle beim erfindungsgemäßen Bonden immer radialsymmetrisch vom Zentrum zum Seitenrand und drückt bei diesem Vorgang ein ringförmiges Gaspolster vor sich her. Entlang der, insbesondere näherungsweise kreisringförmigen, Bondlinie (Bondfront) der Bondwelle herrscht eine derart große Bondkraft vor, dass Einschlüsse von Gasblasen gar nicht erst entstehen können. Das obere/zweite Substrat liegt daher während des Bondvorgangs auf einer Art Gaspolster. Die Ausprägung und Widerstand des Gaspolsters wird durch die Ausführungsformen beeinflusst.

Alle erwähnten erfindungsgemäßen Ausführungsformen können in einer speziellen Ausführungsvariante im Niedervakuum, mit größerem Vorzug im Hochvakuum, mit noch größerem Vorzug im Ultrahochvakuum durchgeführt, insbesondere bei einem Druck von weniger als 100 mbar, mit Vorzug weniger als 10⁻¹ mbar, mit größerem Vorzug weniger als 10⁻³ mbar, mit noch größerem Vorzug weniger als 10⁻⁵ mbar, mit allergrößtem Vorzug weniger als 10⁻⁸ mbar. Weitere Ausführungsformen können bei Normaldruck (Atmosphärendruck) oder im Überdruck betrieben werden.

In einer weiteren erfindungsgemäßen Ausführungsform kann das Gaspolster lokal und dynamisch durch Druckerhöhung entgegenwirken, sodass bei stetig steigendem Gegendruck das Voranschreiten und das Ausbreiten der Bondwelle insbesondere verlangsamt oder gehindert werden.

Es ist alternativ eine Druckverminderung für die Beschleunigung der Bondwelle in einer anderen erfindungsgemäßen Ausführungsform möglich

Der zeitliche Ablauf des Verlaufs der Bondwelle wird insbesondere mit der Veränderung des Drucks beeinflusst, somit gibt es eine Korrelation zwischen dem Verlauf der Bondwelle und der Druckänderung.

Es soll somit eine Beziehung eines steigenden (Gegen)drucks in der Zeit hergestellt werden, welche mathematisch als Funktion beschrieben werden kann. Für die erfindungsgemäße Hinderung der Bondwelle soll die Funktion des Drucks (auch als Druckgradient genannt) in der Bondkammer, insbesondere zwischen den Substraten mittels streng monoton steigenden Funktionen beschreibbar sein, welche für die Verlangsamung der Bondwelle verwendet werden können. Für die Beschleunigung gilt entsprechend, daß der Druckgradient mit streng monoton fallenden oder konstanten Funktionen beschreibbar sein soll.

Diese Druckänderung in der Zeiteinheit beträgt mehr als 1 mbar/s, mit Vorzug mehr als 10 mbar/s, mit größerem Vorzug mehr als 100 mbar/s, mit noch größerem Vorzug mehr als 500 mbar/s, bevorzugter mehr als 1000 mbar/s, im Idealfall mehr als 2000 mbar/s. Ein insbesondere wichtiger erfindungsgemäßer Gedanke liegt in der schnellen und reproduzierbar zu ändernden Bondkammerdruck bzw. Gaszusammensetzung zwischen Ultrahochvakuum und Überdruck.

Durch erfindungsgemäße Auswahl eines Gases/Gasgemisches und Definition der Eigenschaften des Gaspolsters wird festgelegt, wie schnell und wie stark sich das zweite Substrat absenken und/oder dehnen kann. Des Weiteren kann über die Eigenschaften des Gases auch die Geschwindigkeit der Bondwelle gesteuert werden.

Gemäß einem weiteren, insbesondere eigenständigen, Aspekt der Erfindung wird die Zusammensetzung des Gasgemisches gewählt. Mit Vorzug werden Gase mit möglichst leichten Atom- und/oder Molekülsorten verwendet, die bei gegebener Temperatur eine entsprechend geringe Trägheit besitzen. Insbesondere werden Inertgase und/oder schwach reagierende Gase bevorzugt verwendet. Mit besonderem Vorzug wird eines der folgenden Gase bzw. Gasgemische verwendet
- Inertgase sowie wenig reaktive Gase, insbesondere
   ∘ Stickstoff, Argon, Helium, Kohlenstoffdioxid
- Reaktive Gase, insbesondere
   ∘ Wasserstoff, Kohlenmonoxid, Ammoniak, Wasserdampf, Sauerstoff

Daher ist die molare Masse mindestens einer der Gaskomponenten kleiner als 1000 g/mol, mit Vorzug kleiner als 100 g/mol, mit größerem Vorzug kleiner als 10 g/mol, mit allergrößtem Vorzug kleiner als 1 g/mol. Mit Weiteren Vorzug wird die Dichte des verwendeten Gasgemisches, insbesondere so gering wie möglich und/oder die Temperatur, insbesondere so hoch wie nötig, eingestellt. Die Gasdichte wird erfindungsgemäß kleiner als 10 kg/m³, mit Vorzug kleiner als 1 kg/m³, mit größerem Vorzug kleiner als 0.1 kg/m³, mit allergrößtem Vorzug größer als 0.01 kg/m³ eingestellt. Die Temperatur des Gases wird erfindungsgemäß größer als -100°C, bevorzugt größer als -50°C, noch bevorzugter größer 0°C, mit noch größerem Vorzug größer als 100°C, mit noch größerem Vorzug größer als 200°C, mit größtem Vorzug größer als 300°C, mit allergrößtem Vorzug größer als 400°C eingestellt.

Erfindungsgemäß werden die vorgenannten Parameter so gewählt, dass das gewählte Gasgemisch bzw. einzelne Komponenten des Gasgemisches nicht kondensieren. Hierdurch werden Flüssigkeitseinschlüsse an der Oberfläche der Substrate während des Bondvorgangs vermieden.

Für Gasgemische, deren thermodynamische Eigenschaften in Mehrkomponentenphasendiagrammen dargestellt werden, gelten analoge Überlegungen. Durch die Änderung von Zusammensetzung und/oder Druck und/oder Temperatur des Gasgemisches wird die Kinematik des ersten und/oder zweiten Substrats beeinflusst und damit auch der "run-out" Fehler vermindert.

Ein weiterer, insbesondere eigenständiger, Erfindungsaspekt besteht darin, die Verformung des ersten Substrats und/oder des zweiten Substrats abhängig von vorgegebenen Einflussfaktoren auf den Verlauf der Bondwelle zu steuern. Zu den Einflussfaktoren zählen unter anderem der Umgebungsdruck der die Substrate umgebenden Atmosphäre, die Art des in der Atmosphäre vorliegenden Gas/Gasgemisches, die Temperatur, der Abstand zwischen den Substraten außerhalb der Bondinitiierungsstelle, die Bondstärke der Substrate, etwaige Vorbehandlungsschritte, die Beschaffenheit der Oberflächen, die Oberflächenrauigkeit, die Materialien an der Oberfläche sowie Waferdicke/Biegesteifigkeit.

Soweit die Bondinitiierungsstelle im Zentrum der Kontaktflächen der Substrate angeordnet wird, ist ein gleichmäßiger, insbesondere konzentrischer Verlauf der Bondwelle realisierbar.

Besonders vorteilhaft ist es, wenn die Verformung des ersten Substrats und/oder des zweiten Substrats in lateraler Richtung und/oder konvex und/oder konkav erfolgt, noch bevorzugter spiegelsymmetrisch. Mit anderen Worten folgt die Verformung erfindungsgemäß insbesondere durch Dehnung oder Stauchung oder Krümmung des ersten Substrats und/oder des zweiten Substrats.

Bevorzugt weisen die Substrate annähernd identische Durchmesser auf, die insbesondere um weniger als 5 mm, vorzugsweise weniger als 3 mm, noch bevorzugter weniger als 1 mm, voneinander abweichen.

Die Aufnahme und Fixierung der Substrate auf Aufnahmeeinrichtungen kann auf jede erdenkliche Art mit jeder bekannten Technologie erfolgen. Erfindungsgemäß denkbar sind insbesondere Vakuumprobenhalter, elektrostatische Probenhalter, Probenhalter mit mechanischer Klemmung. Mit Vorzug werden die Substrate ausschließlich an einem möglichst weit außen liegenden Kreissegment im Bereich des Seitenrandes fixiert, um den Substraten weitestgehende Flexibilität und Dehnungsfreiheit innerhalb der Fixierung zu gewähren.

Die Substrate (Wafer) werden vor dem Bondvorgang zueinander ausgerichtet, um Deckungsgleichheit (exakte Ausrichtung, insbesondere mit einer Genauigkeit von weniger als 2µm, vorzugsweise weniger als 250nm, noch bevorzugter weniger als 150nm, am bevorzugtesten weniger als 100nm, im Optimalfall weniger als 50nm) korrespondierender Strukturen auf deren Oberflächen zu gewährleisten. Bei dem erfindungsgemäßen Bondverfahren werden die Wafer nicht plan aufeinander gelegt, sondern zunächst in der Mitte miteinander in Kontakt gebracht, indem einer der beiden Wafer leicht gegen den zweiten Wafer gedrückt wird beziehungsweise entsprechend in Richtung des gegenüberliegenden Wafers verformt wird. Nach dem Loslösen des verformten (in Richtung des gegenüberliegenden Wafers) durchgebogenen Wafers erfolgt durch das Voranschreiten einer Bondwelle ein kontinuierliches und gleichmäßigeres, mit minimalster Kraft und damit mit minimalsten, vorwiegend horizontalen, Verzerrungen verbundenes, insbesondere zumindest überwiegend selbsttätiges, Verschweißen entlang der Bondfront.

Mit besonderem Vorzug werden alle veränderbaren Parameter so gewählt, dass die Bondwelle sich mit einer möglichst optimalen Geschwindigkeit bezüglich der vorhandenen Anfangs- und Randbedingungen ausbreitet. Vor allem bei vorhandener Atmosphäre, insbesondere Normaldruck, ist eine möglichst langsame Geschwindigkeit der Bondwelle vorteilhaft. Die Geschwindigkeit der Bondwelle ist dabei geringer als 50 cm/s, mit größerem Vorzug gering er als 10 cm/s, mit größerem Vorzug geringer als 1 cm/s, mit größtem Vorzug geringer als 0,1 cm/s, mit allergrößtem Vorzug geringer als 0,01 cm/s. Insbesondere ist die Geschwindigkeit der Bondwelle kleiner als 0,001 cm/s. Insbesondere ist die Geschwindigkeit der Bondwelle entlang der Bondfront konstant. In einer Vakuumumgebung wird die Geschwindigkeit der Bondwelle automatisch schneller, da die sich entlang der Bondlinie verbindenden Substrate keinen Widerstand durch ein Gas überwinden müssen. Eine besonders bevorzugte Ausführungsform wirkt diese Beschleunigung der Bondwelle mit dem gezielten Einsatz des Überdrucks entgegen und verlangsamt die Geschwindigkeit der Bondwelle um mehr als 0,1 cm/s, mit Vorzug um mehr als 1 cm/s, mit größerem Vorzug um mehr als 10 cm/s, mit besonderem Vorzug um mehr als 100 cm/s, im optimalen Fall um mehr als 200 cm/s, im Idealfall mit 1000 cm/s, im theoretischen Fall kann die Ausbreitung der Bondwelle durch den Überdruck (bis zum Erreichen eines technologisch-materiell bedingten Grenzdrucks) gestoppt werden.

Gemäß einem weiteren, insbesondere eigenständigen, Erfindungsaspekt wird der "run-out" Fehler durch einen sehr geringen Abstand zwischen den beiden Substraten vor der Kontaktierung und/oder außerhalb der Bondinitiierungsstelle eingestellt. Der Abstand beträgt insbesondere weniger als 100µm, mit Vorzug weniger als 50µm, mit größerem Vorzug weniger als 20µm, mit allergrößtem Vorzug weniger als 10µm.

Mit der Einstellung des Abstandes kann ein zu verdrängendes Gasvolumen abgeschätzt werden. Dafür können die Substrate als unendlich steife Platten aufgefasst werden. Dieses charakteristische Volumen setzt sich aus der Fläche eines zu bondenden ersten Substrates oder eines zweiten Substrates (A1 bzw. A2), mal dem Abstand (h) der Substrate zueinander zusammen. Das Verdrängungsvolumen wird von dem äußeren Umfang des Substratstapels virtuell abgegrenzt. Diese näherungsweise zylinderförmige virtuelle Fläche stellt eine Grenze (M, M', M") der Gasströmung dar, wo durch die Bondwelle das Gaspolster in die Bondkammer herausgedrückt wird und/oder das Gas herausströmt und/oder abgesaugt wird.

Der Höchstabstand vor Initiierung des Prebondes kann dabei weniger als 1000 µm, mit Vorzug weniger als 500 µm, mit besonderem Vorzug weniger als 200 µm, noch bevorzugter weniger als 100 µm, im besonders bevorzugten Fall weniger als 50 µm betragen kann. Korrespondierend zu diesen Abständen stellt sich bei einem Substratdurchmesser von 200 mm ein Verdrängungsvolumen kleiner 31 ml, bevorzugter kleiner 16 ml, noch bevorzugter kleiner 6 ml, besonders bevorzugt kleiner 3 ml, am allerbevorzugtesten kleiner 2 ml ein.

Bei einem Substratdurchmesser von 300 mm stellt sich ein Verdrängungsvolumen kleiner 71 ml, bevorzugter kleiner 35 ml, noch bevorzugter kleiner 14 ml, besonders bevorzugt kleiner 7 ml, am allerbevorzugtesten kleiner 4 ml ein.

Die Steuerung und/oder Regelung der vorbeschriebenen Schritte und/oder Bewegungen und/oder Abläufe, insbesondere die Annäherung der Substrate zueinander, die Temperatur-, Druck- und Gaszusammensetzungskontrolle, erfolgt mit Vorzug über eine zentrale Steuereinheit, insbesondere einen Computer mit einer Steuerungssoftware.

Für eine Regelung ist die Verwendung von entsprechenden Sensoren für die Anwendung in elektrischen und/oder elektronisch betriebenen insbesondere geschlossenem Regelkreis oder Regelkreisen notwendig. Diese Sensoren werden verwendet, um für eine Aufnahme und/oder Verarbeitung und/oder Weitergabe des jeweiligen zu messenden Einflussfaktors oder deren Kombinationen zu ermöglichen. Die Sensoren können in der Bondkammer insbesondere Temperatur, Druck, Gaszusammensetzung, Verformung, Partikelanzahl, Ausrichtungszustand der Substrate, Position, Geschwindigkeit und Verlauf der Bondwelle erfassen.

Dementsprechend können Thermometer, Drucksensoren, Gaschromatographen, Dehnungs- und Verformungsmessgeräte, Partikelzähler, optische bzw. vergrößernde optische Instrumente (Messmikroskope) mit Bildaufnahmefunktionalitäten, Positionserfassungssysteme (taktil und/oder kapazitiv und/oder induktiv oder optisch-inkrementell sowie vollständig optisch berührungslos wie Kamerasysteme, Lasertriangulations- oder Laserinterferometersysteme angewendet werden.

Nach der Erfassung kann ein Computer mit entsprechender Ausstattung an Messerfassungs- Analyse- und Darstellungsmöglichkeiten dazu verwendet werden, aus Einzelwerten Statistiken, Auswertungen sowie Prognosen zu liefern.

Die Statistik oder Analyse wird erfindungsgemäß zu einer Einstellung und Nachstellung der Bondparameter verwendet, insbesondere für die Vorbereitung des produktiven Einsatzes der Anlage, welche als HVM (high volume manufacturing) bezeichnet werden kann.

Eine erfindungsgemäß mögliche Abfolge der Schritte kann aus den folgenden Schritten bestehen:
In einem ersten (iterativen) erfindungsgemäßen Verfahrensschritt wird eine bestimmte Anzahl n von Substraten zu n/2 Testsubstratpaaren gefügt.

In einem zweiten (iterativen) erfindungsgemäßen Verfahrensschritt werden die Testsubstratpaare in einer entsprechenden Vermessungsanlage auf run-out vermessen und analysiert.

In einem dritten (iterativen) erfindungsgemäßen Verfahrensschritt wird die Statistik des run-outs mit der Statistik der Bondparameter abgeglichen.

In einem vierten (iterativen) erfindungsgemäßen Verfahrensschritt werden die zielführenden Parameter dem Fachmann bekannter Weise sowohl zur Ausrichtung, als auch zur Beeinflussung der Bondwelle eingestellt.

Die Iterationen werden bis zum Unterschreiten eines definierten Fehlers bzw. Abbruchkriteriums widerholt.

In einem fünften erfindungsgemäßen Verfahrensschritt kann die Anlage für die Produktion freigegeben werden.

Vorrichtungsgemäß offenbarte Merkmale sollen auch als verfahrensgemäß offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: eine schematische Querschnittansicht einer erfindungsgemäßen Bondkammer während eines ersten Schritts eines erfindungsgemäßen Verfahrens,
- Figur 2a: eine schematische Querschnittansicht des Bondvorgangs während eines zweiten Schritts,
- Figur 2b: eine schematische Querschnittansicht des Bondvorgangs während eines dritten Schritts,
- Figur 3: eine schematische Querschnittansicht einer weiteren Ausführungsform einer erfindungsgemäßen Bondkammer,
- Figur 4: eine schematische Querschnittansicht einer weiteren Ausführungsform einer erfindungsgemäßen Bondkammer,
- Figur 5: eine schematische Querschnittansicht einer weiteren Ausführungsform einer erfindungsgemäßen Bondkammer,
- Figur 6: eine schematische Querschnittansicht einer weiteren Ausführungsform einer erfindungsgemäßen Bondkammer,
- Figur 7: eine schematische Blockdarstellung einer weiteren erfindungsgemäßen Bondkammer,
- Figur 8: ein Diagramm, welches den zeitlichen Ablauf eines Druckverlaufs darstellt.

In den Figuren sind gleiche Bauteile und Bauteile mit der gleichen Funktion mit den gleichen Bezugszeichen gekennzeichnet.

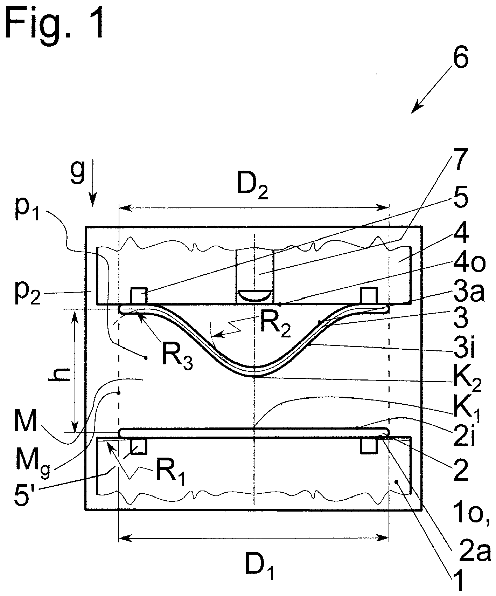

In Figur 1 ist eine erfindungsgemäße Bondkammer 6 gemäß einer beispielhaften Ausführungsform während eines ersten Schritts eines beispielhaften erfindungsgemäßen Verfahrens schematisch dargestellt. Die Richtung der Gravitation g ist dargestellt. In der Bondkammer 6 befindet sich ein unterer Substrathalter, auch Chuck genannt 1 mit einer funktionellen Oberfläche 1o, welche einen Krümmungsradius R1 besitzen kann, vorhanden. Weiterhin sind Befestigungsmittel 5' auf/an der funktionellen Oberfläche, insbesondere Vakuumbahnen zur Befestigung des unteren Substrates 2 vorgesehen. Das untere Substrat befindet sich mit einer äußeren Oberfläche 2a auf der funktionellen Oberfläche 1o des unteren Substrathalters 1. Die zu bondende innere Substratoberfläche 2i ist mit dem bevorzugten Punkt der künftigen Bondinitiierungsstelle als erster Kontaktpunkt K1 aufgeführt. Das obere Substrat 3 befindet sich in einem Abstand h vom unteren Substrat 2. Die zu bondende innere Oberfläche 3i des oberen Substrates 3 liegt der zu bondenden inneren Oberfläche 2i des unteren Substrats 2 gegenüber. Der Kontaktpunkt der Bondinitiierungsstelle des oberen Substrates 3 wird als zweiter Kontaktpunkt K2 dargestellt. Das obere Substrat 3 wird an einer äußeren Oberfläche 3a an der funktionellen Oberfläche 4o eines oberen Substrathalters 4 durch Befestigungsmittel 5 gehalten. Wegen der Wirkung der Gravitation hängt das obere Substrat 3 auf dem Fachmann bekannte Weise durch, was näherungsweise mit den Radien R2, R3 beschrieben werden kann. Ein Raumabschnitt M wird zwischen dem unteren Substrat 2 und dem oberen Substrat 3 ausgebildet. Innerhalb des Raumabschnitts M herrscht ein Druck p1, in der Bondkammer kann ein Druck p2 außerhalb des Raumabschnitts M beobachtet werden. Eine Raumabschnittgrenzfläche Mg des Raumabschnittes M wird als Beobachtungsfläche definiert. Ein Pin 7 leitet die Bondwelle ein.

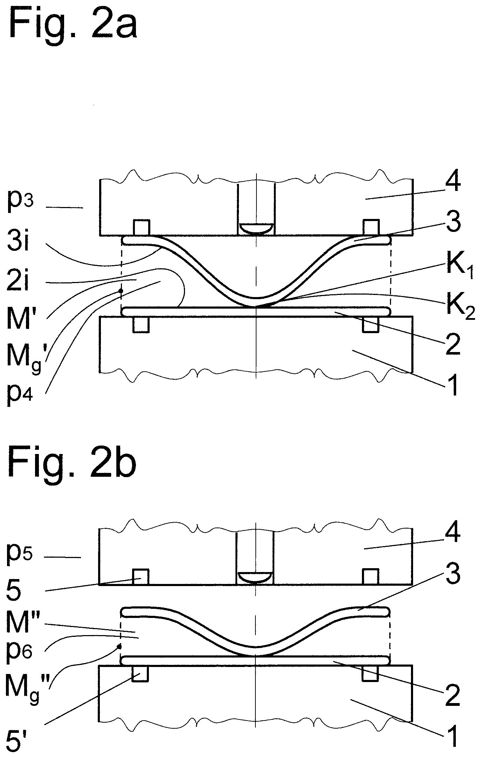

Fig. 2a stellt eine schematische Abbildung der Bondkammer während eines Bondprozesses dar. Die beiden Substrathalter 1 und 4 wurden durch nicht eingezeichnete Positioniermittel soweit zueinander angenähert, dass die Kontaktpunkte K1 und K2 aufeinander treffen. Die Bondwelle kann sich zwischen den zu bondenden inneren Oberflächen 2i sowie 3i der Substrate 2 und 3 ausbreiten. Innerhalb eines Raumabschnitts M' wird ein Druck p4 beobachtet. Außerhalb des Raumabschnitts M' wird ein Druck p3 mit nicht eingezeichneten Mitteln beeinflusst, wobei dies lokal, insbesondere ringförmig an einer Raumabschnittgrenzfläche Mg' des Raumabschnitts M' mit Wirkung und Veränderung auf p4 erfolgt. Durch die Verwendung von Beeinflussungsmitteln, insbesondere Düsen, kann der Druck im gesamten Raumabschnitt M' nicht sprunghaft geändert werden sondern muss sich über den Raumabschnitt M' zeitlich und örtlich ändern. Es existiert damit, zumindest anfangs, keine homogene Druckverteilung. Die Druckverteilung ist im Allgemeinen, insbesondere am Beginn des Prozesses, eine Funktion von Ort und Zeit. Sind die Beeinflussungsmittel Düsen, welche sich außerhalb des Raumabschnittes M' befinden und auf die Raumabschnittsfläche Mg' einwirken, kann eine ringförmig ausgebildete isobare Gegend erzeugt werden, welche für eine kleine Zeiteinheit, insbesondere infinitesimal kleine Zeiteinheit, besteht. Die Zeiteinheit ist insbesondere kleiner als 1 s, vorzugsweise kleiner als 0.1 s, noch bevorzugter kleiner als 0.01 s, am bevorzugtesten kleiner als 0.0001 s, am allerbevorzugtesten kleiner als 0.00001 s. Die Druckverteilung kann damit insbesondere durch ein Isobarenschaubild bei einem gewissen Zeitpunkt grafisch dargestellt/simuliert/berechnet werden.

Fig. 2b stellt eine weitere schematische Abbildung der Bondkammer 6 während eines weiteren Schrittes des Bondprozesses dar. Dabei wird das obere Substrat 3 durch Lösen des Befestigungsmittels 5 von dem oberen Substrathalter 4 fallengelassen. Optional kann sich das untere Substrat 2 ebenfalls durch Lösen des Befestigungsmittels 5' frei verformen und dadurch die Verzerrung minimieren. Innerhalb eines Raumabschnitts M" wird ein Druck p6 beobachtet. Außerhalb des Raumabschnitts M" wird ein Druck p5 mit nicht eingezeichneten Mitteln beeinflusst, wobei dies lokal, insbesondere ringförmig, an einer Raumabschnittgrenzfläche Mg" des Raumabschnitts M" mit Wirkung und Veränderung auf p6 erfolgt.

Durch die erfindungsgemäße, lokale und dynamische Erhöhung des Drucks p5 kann das Voranschreiten der Bondwelle insbesondere verlangsamt werden. Ein stationärer Zustand mit homogenem Druck würde die Bondwelle beschleunigen, da das Bestreben sich besser aneinander zu schmiegen durch die bereits miteinander verbondeten Substratabschnitte des Stapels zunimmt. Je größer das Bestreben der Substrate ist, miteinander zu verbonden, desto größer würde auch die Kraft sein, sie wieder voneinander zu trennen. Falls p6 kleiner ist als p5, würde die Bondwelle beschleunigt. Erfolgt die Druckerhöhung von p5 an der Raumabschnittgrenzfläche Mg" dynamisch so, dass p6 durch die Druckdifferenz zwischen p5 und p6 höher ist als p5, wird die Bondwelle verlangsamt. In anderen Worten ist es so, dass wenn p6 größer ist als p5, die Bondwelle verlangsamt wird.

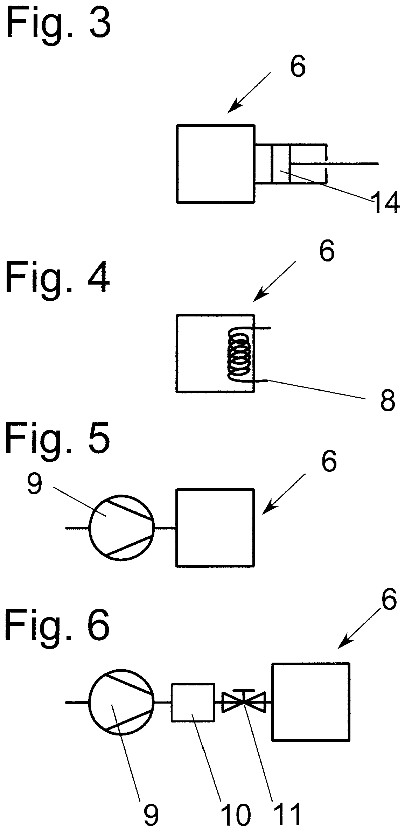

Fig. 3 stellt eine schematische Blockzeichnung einer ersten Ausführungsform einer Bondkammer 6 dar, wobei die insbesondere dynamische und stetige Erhöhung des Kammerdrucks mittels Veränderung des Bondkammervolumens, insbesondere mittels Kolben 14 erfolgt, sodass die Teilchenanzahl in der Bondkammer 6 während des Bondprozesses in einem Beobachtungszeitraum, insbesondere zwischen den nicht eingezeichneten Endstellungen des Kolbens bei sich änderndem Druck konstant bleibt. Bei Volumenänderung der abgeschlossenen Bondkammer kommen dementsprechend keine Gasteilchen ins abgeschlossene System des Bondkammervolumens; es werden auch keine Teilchen entzogen. So bleibt die Teilchenanzahl konstant und somit können die Gasgesetze für ideale Gase angewendet werden. Bei der Ausführungsform ist eine gezielte Zuleitung des erzeugten Überdrucks im Falle einer Kompression über bspw. ein Düsensystem, beschrieben in Fig. 2 an die geeignete Stelle zu führen.

Fig. 4 ist eine schematische Blockzeichnung einer zweiten Ausführungsform einer Bondkammer 6. Dabei wird die erfindungsgemäße Erhöhung des Drucks über die Veränderung, insbesondere Erhöhung der Temperatur durch geeignete Heizmittel 8 erfolgt. Die Anzahl der Teilchen in der Bondkammer 6 während des Bondprozesses kann bei einem abgeschlossenen System konstant bleiben. Bei Temperaturänderung der abgeschlossenen Bondkammer kommen dementsprechend keine Gasteilchen ins abgeschlossene System des Bondkammervolumens; es werden auch keine Teilchen entzogen. So bleibt die Teilchenanzahl konstant und somit können die Gasgesetze für ideale Gase angewendet werden. Bei der Ausführungsform ist eine gezielte Zuleitung des erzeugten Überdrucks (erzeugt durch thermischen Energiezufuhr) über bspw. ein Düsensystem, beschrieben in Fig. 2 an die geeignete Stelle zu führen.

Fig. 5 stellt eine schematische Blockzeichnung einer dritten erfindungsgemäßen Ausführungsform einer Bondkammer 6 dar, wobei die insbesondere dynamische und stetige, Erhöhung des Kammerdrucks durch geeignete Verdichteraggregate 9, Pumpen erfolgen kann. Es können partikelfreie Luft, Stickstoff, Argon, Helium, Kohlenstoffdioxid oder andere Inertgase mit hohem Druck in die Bondkammer gepumpt werden. Wie in Fig. 2 diskutiert und hier nicht eingezeichnet, kann eine gezielte Zuleitung des erzeugten Überdrucks über ein geeignetes Düsensystem die Bondwelle erfindungsgemäß beeinflussen.

Fig. 6 stellt eine Erweiterung der in Fig. 5 dargestellten dritten Ausführungsform einer Bondkammer 6 dar. Hier wird ein Überdruck mittels Verdichteraggregat 9 erzeugt, welche einen Speicher 10, insbesondere ein Druckbehälter füllt. Durch geeignete Ventile 11 kann der Überdruck ebenfalls wie bei Fig. 2a, 2b offenbart, an die entsprechende Stellen der Raumabschnittgrenzfläche Mg' bzw. Mg" geleitet und mittels Düsensystem die Bondwelle lokal beeinflusst werden. Erfindungsgemäß erfolgt die Einbringung des Gases vorzugsweise in der Nähe des Bondinterfaces, sodass das schlagartig einströmende Gas einen Überdruck p4 korrespondierend zu Fig. 2a erzeugt. Der Überdruck p4 unterscheidet sich dabei zumindest für eine kurze Zeitspanne von dem Druck p3 und beeinflusst damit die Bondwellengeschwindigkeit.

Das Düsensystem besteht im Allgemeinen aus mindestens zwei Düsen, vorzugsweise aus mehr als 3 Düsen, noch bevorzugter aus mehr als 5 Düsen, mehr als 7 Düsen, mehr als 10 Düsen. Die Düsen sind vorzugsweise symmetrisch vollumfänglich angeordnet.

In einer weiteren erfindungsgemäßen Ausführungsform verwendet man eine Düse mit einem am Umfang verlaufenden Spalt, welcher insbesondere rundherum geschlossen, also vollumfänglich, ausgebildet sein kann. Somit können vorteilhafte Strömungsverhältnisse am jeweiligen Raumabschnitt M, M', M" erzeugt werden.

Wird in einer weiteren erfindungsgemäß vorteilhaften Ausführungsform mehr als eine Spaltdüse verwendet, kann durch unterschiedliche Gaszuleitungen und unterschiedliche Prozessgase der Partialdruck eines jeweiligen zugeführten Gases in der Kammer eingestellt werden. Die Summe aller Partialdrücke ergibt den Bondkammerdruck. Unter Umständen ist es denkbar, nicht nur Inertgase, sondern reaktive Gase wie Wasserdampf, Kohlenwasserstoffe, fluorierte Kohlenwasserstoffe, Silane, fluorierte Silane in die Bondkammer zu leiten. Somit ist beispielsweise eine Verhinderung der Kondensation von Monolagen vom Wasser möglich oder in besonderen Fällen die Sättigung der Atmosphäre mit einem zugeführten Gas erreichbar. Anderes Ziel kann es sein, eine, durch die Gase erhöhte Hafteigenschaft des Bondes, zu erreichen.

Bei einer ersten Ausführungsform ist die Anzahl der Spaltdüsen genau eins, bei einer weiteren Ausführungsform ist mehr als eine Spaltdüse vorhanden, bspw. genau zwei Spaltdüsen. Die Anzahl der Spaltdüsen kann aber mehr als zwei betragen, in einer weiteren Ausführungsform mehr als drei, in einer besonders bevorzugten Ausführungsform mehr als fünf Spaltdüsen betragen.

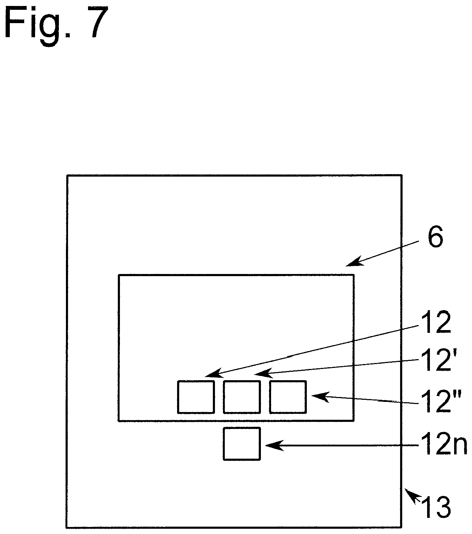

Fig. 7 ist eine schematische Blockzeichnung einer Bondanlage 13, welche mindestens eine Bondkammer 6 beinhaltet. Die Bondkammer 6 kann über eine Anzahl Sensoren 12, 12', 12", 12n verfügen, wobei n die Anzahl der verwendeten Sensoren beschreibt. Es können mehr als 2, bevorzugt mehr als 5, noch bevorzugter mehr als 10, am bevorzugtesten mehr als 20 Sensoren in der Bondkammer angeordnet sein. Die Sensoren können zu Clustern zusammengefasst sein. Die Sensoren 12 und/oder 12' und/oder 12" können eine Ansammlung von einer Anzahl aus beliebigen n unterschiedlichen Sensoren darstellen. Es ist eine zielführende Positionierung aller Sensoren 12 in der Anlage 13 sowie in der Bondkammer 6 zulässig, sodass in als 12n dargestellte Sensoren sich ebenfalls in der Bondkammer 6 befinden können. Die Sensoren können die Werte und Vorgänge in der Bondkammer sowie in der Bondanlage 13 erfassen und an nicht dargestellte Recheneinheiten, weitere Anlagen, insbesondere Computer zur Analyse, Datenauswertung, Fehleranalyse sowie Prognosen weitergeben. Es ist eine auf dem Fachmann bekannte Weise ausgeführte Regelschleife aus Messanlagen und Bondanlagen zur Hochvolumenproduktion ebenfalls denkbar.

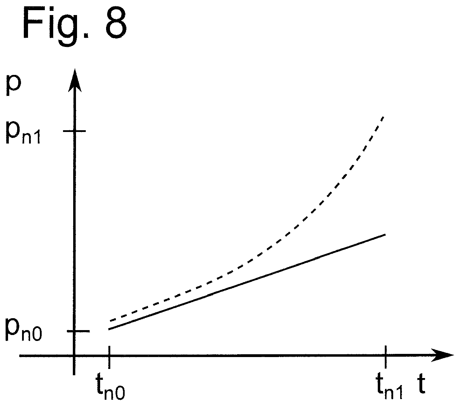

Fig. 8 stellt exemplarisch ein Diagramm des zeitlichen Ablaufs des Drucks während des Bondprozesses, insbesondere Fusionsbonden dar. Vorzugsweise gilt für die erfindungsgemäßen Funktionen, dass sie (im Beobachtungszeitraum) streng stetig monoton steigend sind. Für den Druckverlauf sind zwei exemplarische Kurven eingezeichnet, eine durchgezogene Kurve stellt eine lineare Funktion, eine zweite Kurve, dargestellt in Strichlinie eine exponentielle Funktion dar. Mit anderen Worten soll die Ableitung der Funktion dp/dt bei jedem beliebigen Zeitpunkt t im Betrachtungsintervall positiv sein.

tn0 stellt einen beliebigen Startzeitpunkt der Beobachtung dar, tn1 stellt einen technologisch relevanten späteren Zeitpunkt dar.

Bei Anfang der Beobachtung kann ein Druck pn0 insbesondere im Beobachtungsvolumen M, M', M" registriert werden. Beim erfindungsgemäß ablaufendem Bond wird in der Bondkammer 6, insbesondere im virtuellen Beobachtungsvolumen M, M', M" ein höherer Druck pn1 im Zeitpunkt tn1 beobachtet, welcher mittels beliebiger streng stetig monoton steigender Funktion beschrieben wird.

In speziellen erfindungsgemäßen Ausführungsformen kann es notwendig werden, den Druck nicht streng monoton steigen zu lassen, sondern konstant zu halten. Insbesondere ist es auch möglich, den Druck ab einem gewissen Zeitpunkt, konstant zu halten, ihn also nicht mehr monoton steigen zu lassen.

### Bezugszeichenliste

- 1: Erste, insbesondere untere Aufnahmeeinrichtung, Substrathalter
- 1o: Funktionelle Oberfläche der ersten Aufnahmeeinrichtung
- 2: Erstes, insbesondere unteres Substrat
- 2a: Äußere Fläche des ersten Substrats
- 2i: Innere, zu bondende Fläche des ersten Substrats
- K1, K2: Kontaktpunkte
- 3: Zweites, insbesondere oberes Substrat
- 3i: Innere, zu bondende Fläche des zweiten Substrats
- 3a: Äußere Fläche des zweiten Substrats
- 4: Zweite, insbesondere obere Aufnahmeeinrichtung, Substrathalter
- 4o: Funktionelle Oberfläche der zweiten Aufnahmeeinrichtung
- 5, 5': Befestigungsmittel
- 6: Bondkammer
- 7: Pin zur Initiierung des Bonds
- D1, D2: Durchmesser der Substrate
- g: Wirkrichtung der Gravitation
- R1: Radius des ersten Substrathalters
- R2, R3: Radien der Durchhängung
- h: Abstand der Substrate zueinander
- M, M', M": Raumabschnitt
- Mg, Mg', Mg": Raumabschnittgrenzfläche
- p1, p2, p3, p4, p5, p6: Druck
- 8: Heizvorrichtung
- 9: Verdichter
- 10: Druckbehälter
- 11: Ventil
- 12, 12', 12", 12n: Sensoren und/oder Messinstrumente
- 13: Anlage zum Bonden
- 14: Kolben
- p: Druck
- dp: Druckdifferenz
- dt: Zeitdifferenz
- t: Zeit
- pn0, pn1: Drücke bei unterschiedlichen Beobachtungszeitpunkten
- tn0, tn1: Beobachtungszeitpunkte

## Patentansprüche

1. Verfahren zum Bonden, bevorzugt Permanentbonden, insbesondere Fusionsbonden, eines ersten Substrats (2) mit einem zweiten Substrat (3) innerhalb einer abgeschlossenen Bondkammer (6), aufweisend die folgenden Schritte:
a) Fixierung der Substrate (2, 3),
b) Anordnung der Substrate (2, 3),
c) Annäherung der Substrate (2, 3),
d) Kontaktierung der Substrate (2, 3) an einer Bondinitiierungsstelle (K1, K2),
e) Erzeugung einer entlang einer von der Bondinitiierungsstelle (K1, K2) zu Seitenrändern der Substrate (2, 3) verlaufenden Bondwelle,
f) Beeinflussung der Bondwelle, wobei die Beeinflussung der Bondwelle durch eine Änderung der Atmosphäre in der Bondkammer (6) erfolgt.

2. Verfahren nach Anspruch 1, wobei im Schritt f) die Beeinflussung der Bondwelle durch geregelte und/oder gesteuerte Veränderung der Gaszusammensetzung, der Dichte, des Wassergehalts und/oder der Temperatur innerhalb der Bondkammer (6) erfolgt.

3. Verfahren nach mindestens einem der vorhergehenden Ansprüche, wobei in der Bondkammer (6) ein Gas mit leichten Atom- und/oder Molekülsorten verwendet wird, das bei gegebener Temperatur eine geringe Trägheit besitzt.

4. Verfahren nach mindestens einem der vorhergehenden Ansprüche, wobei in der Bondkammer (6) ein Inertgas und/oder schwach reagierendes Gas verwendet wird.

5. Verfahren nach mindestens einem der vorhergehenden Ansprüche, wobei in der Bondkammer (6) eines der folgenden Gase bzw. Gasgemische verwendet wird:
• Inertgase sowie wenig reaktive Gase, insbesondere
∘ Stickstoff, Argon, Helium, Kohlenstoffdioxid
• Reaktive Gase, insbesondere
∘ Wasserstoff, Kohlenmonoxid, Ammoniak, Wasserdampf, Sauerstoff.

6. Verfahren nach mindestens einem der vorhergehenden Ansprüche, wobei im Schritt e) die Fixierung mindestens eines der Substrate (2, 3) beibehalten wird und die Substrate (2, 3) geregelt einander angenähert werden und dadurch die Bondwelle erzeugt wird, und im Schritt f) die Beeinflussung der Bondwelle durch geregelte und/oder gesteuerte Veränderung des Abstandes der Substrate (2, 3) erfolgt.

7. Verfahren nach mindestens einem der vorhergehenden Ansprüche, wobei die Bondwelle derart beeinflusst wird, dass die Geschwindigkeit der Bondwelle um mehr als 0,1 cm/s, mit Vorzug um mehr als 1 cm/s, mit größerem Vorzug um mehr als 10 cm/s, mit besonderem Vorzug um mehr als 100 cm/s, im noch mehr bevorzugten Fall um mehr als 200 cm/s, im bevorzugtesten Fall um mehr als 1000 cm/s verlangsamt wird.

8. Verfahren nach mindestens einem der vorhergehenden Ansprüche, wobei die Druckveränderung durch eine Heiz- und/oder Kühleinrichtung (8) erfolgt, wobei die Heiz- und/oder Kühleinrichtung (8) die Temperatur innerhalb der Bondkammer (6) verändert, insbesondere erhöht.

9. Verfahren nach mindestens einem der vorhergehenden Ansprüche, wobei die Druckveränderung durch eine Pumpe (9) erfolgt, wobei die Pumpe (9) ein Gas und/oder Gasgemisch in die Bondkammer (6) pumpt und/oder aus der Bondkammer (6) absaugt.

10. Verfahren nach mindestens einem der vorhergehenden Ansprüche, wobei zur Druckveränderung Gas und/oder ein Gasgemisch aus einem Druckbehälter (10) über ein Ventil (11) in die Bondkammer (6) geleitet wird oder abgelassen wird.

11. Anlage (13) zum Bonden, bevorzugt Permanentbonden, insbesondere Fusionsbonden, eines ersten Substrats (2) mit einem zweiten Substrat (3), insbesondere mit einem Verfahren gemäß einem der vorhergehenden Ansprüche, aufweisend:
a) eine Bondkammer (6),
b) Aufnahmeeinrichtungen (1, 4) zur Aufnahme und Fixierung der Substrate (2, 3), wobei die Aufnahmeeinrichtungen (1, 4) zur Annäherung der Substrate (2, 3), zur Kontaktierung der Substrate (2, 3) und zur Erzeugung einer Bondwelle ausgebildet ist,
c) Beeinflussungsmittel (7, 8, 9, 10, 11) zur Beeinflussung der Bondwelle, wobei die Beeinflussung der Bondwelle durch eine Änderung der Atmosphäre in der Bondkammer (6) erfolgt.

12. Anlage (13) nach mindestens einem der vorhergehenden Ansprüche, wobei die Beeinflussung der Bondwelle durch geregelte und/oder gesteuerte Veränderung der Gaszusammensetzung, der Dichte, des Wassergehalts und/oder der Temperatur innerhalb der Bondkammer (6) erfolgt.

13. Anlage (13) nach mindestens einem der vorhergehenden Ansprüche, wobei in der Bondkammer (6) ein Gas mit leichten Atom- und/oder Molekülsorten verwendet wird, das bei gegebener Temperatur eine geringe Trägheit besitzt.

14. Anlage (13) nach mindestens einem der vorhergehenden Ansprüche, wobei in der Bondkammer (6) ein Inertgas und/oder schwach reagierendes Gas verwendet wird.

15. Anlage (13) nach mindestens einem der vorhergehenden Ansprüche, wobei in der Bondkammer (6) eines der folgenden Gase bzw. Gasgemische verwendet wird:
• Inertgase sowie wenig reaktive Gase, insbesondere
∘ Stickstoff, Argon, Helium, Kohlenstoffdioxid
• Reaktive Gase, insbesondere
∘ Wasserstoff, Kohlenmonoxid, Ammoniak, Wasserdampf, Sauerstoff.

16. Anlage (13) nach mindestens einem der vorhergehenden Ansprüche, wobei die Beeinflussungsmittel (7, 8, 9, 10, 11) Abstandsveränderungsmittel umfassen zur Veränderung des Abstandes der Substrate (2, 3) zur Beeinflussung der Bondwelle.
